# EUROPEAN PATENT APPLICATION

(11) **EP 4 170 460 A1**
(43) Date of publication of application: **26.04.2023**
(21) Application number: 21927497.4
(22) Date of filing: 26.08.2021
(51) Int. Cl.: G06F 1/16

(54) **NOISE REDUCTION METHOD FOR FAN OF LAPTOP AND LAPTOP**

(30) Priority: 25.02.2021 CN 202110211704
(71) Applicant: Honor Device Co., Ltd., Shenzhen, Guangdong 518040 (CN)
(72) Inventor: YANG, Tao, Shenzhen, Guangdong 518040 (CN); ZHAO, Yong, Shenzhen, Guangdong 518040 (CN); GAO, Man, Shenzhen, Guangdong 518040 (CN); HUO, Guoliang, Shenzhen, Guangdong 518040 (CN)
(74) Representative: Maiwald GmbH
(86) International application number: PCT/CN2021/114843
(87) International publication number: WO 2022/179069

(57) **Abstract**

A fan (12) noise reduction method for a notebook computer (10) and the notebook computer (10) that relate to the field of terminal technologies can reduce noise of the fan (12) of the notebook computer (10), thereby resolving a conflict between heat dissipation by the fan (12) and noise of the fan (12) and improving user experience of the notebook computer (10). The notebook computer (10) includes a control chip, a speaker (122), and the fan (12). The control chip and the fan (12) are disposed inside a chassis of the notebook computer (10). The speaker (122) is an internal speaker (122) disposed inside the chassis or the speaker (122) is an external speaker (122) disposed outside the chassis. The method includes: controlling, by the control chip, the speaker (122) to send a first sound signal, where the first sound signal and a first noise signal that is generated by running of the fan (12) have opposite phases and a same frequency. The first sound signal is used to cancel the first noise signal.

## Description

This application claims priority to Chinese Patent Application No. 202110211704.3, filed with the China National Intellectual Property Administration on February 25, 2021 and entitled "FAN NOISE REDUCTION METHOD FOR NOTEBOOK COMPUTER, AND NOTEBOOK COMPUTER", which is incorporated herein by reference in its entirety.

### TECHNICAL FIELD

This application relates to the field of terminal technologies, and in particular, to a fan noise reduction method for a notebook computer, and a notebook computer.

### BACKGROUND

Notebook computers have become everyday important office tools by virtue of their portability and powerful processing capability. Currently, to enhance portability and appearance beauty and achieve extreme lightness and thinness of notebook computers, notebook computers are constantly reduced in thickness, and hence fans for heat dissipation in notebook computers are also becoming thinner. However, as the thickness of a fan is reduced, heat dissipation efficiency of the fan is lowered, which affects the heat dissipation effect of a notebook computer.

At present, the heat dissipation effect of a notebook computer can be guaranteed by increasing the fan speed. However, a high fan speed undoubtedly leads to increased fan noise, which affects user experience of the notebook computer.

### SUMMARY

This application provides a fan noise reduction method for a notebook computer, and a notebook computer, so that fan noise of a notebook computer can be reduced, thereby resolving a conflict between heat dissipation by a fan and fan noise, and improving user experience of a notebook computer.

According to a first aspect, this application provides a fan noise reduction method for a notebook computer. The notebook computer includes a control chip, a speaker, and a fan. The control chip and the fan are disposed inside a chassis of the notebook computer. The speaker is an internal speaker disposed inside the chassis of the notebook computer. Alternatively, the speaker is an external speaker disposed outside the chassis of the notebook computer.

In the method, the notebook computer may control, by using the control chip, the speaker to send a first sound signal. The first sound signal and a first noise signal that is generated by running of the fan have opposite phases and a same frequency. The first sound signal is used to cancel the first noise signal.

In this solution, the notebook computer may control the speaker to send the first sound signal (namely, a reverse-phase acoustic wave) whose phase is opposite to that of the first noise signal and whose frequency is the same as that of the first noise signal, to cancel the noise signal. In this way, fan noise heard by a user can be reduced, thereby resolving a conflict between heat dissipation by the fan and fan noise, and improving user experience of the notebook computer.

In a possible design manner of the first aspect, the speaker is the external speaker. In this design manner, the speaker (namely, the external speaker) may be disposed in a bezel of a display of the notebook computer, and an included angle between a sound emitting direction of the speaker and a plane in which the display is located is within a first preset angle range.

The first preset angle range is determined based on statistics of a large number of users using the notebook computer about included angles between a first direction and the plane in which the display is located. The first direction is parallel to a connection line between a position of the speaker and an ear of the user when the user is using the notebook computer.

It should be understood that the sound emitting direction of the external speaker is parallel to the connection line between the external speaker and the human ear, so that the human ear can better receive the first sound signal sent by the external speaker. This can improve an effect of canceling fan noise (namely, the noise signal) by the first sound signal sent by the external speaker.

In another possible design manner of the first aspect, the speaker is the external speaker. In this design manner, the speaker (namely, the external speaker) may be disposed in a base of the notebook computer at a position close to a keyboard or touchpad of the notebook, and an included angle between a sound emitting direction of the speaker and a plane in which the keyboard or the touchpad is located is within a second preset angle range.

The second preset angle range is determined based on statistics of a large number of users using the notebook computer about included angles between a second direction and the plane in which the keyboard or the touchpad is located. The second direction is parallel to a connection line between the position of the speaker and an ear of the user when the user is using the notebook computer.

It should be understood that the sound emitting direction of the external speaker is parallel to the connection line between the external speaker and the human ear, so that the human ear can better receive the first sound signal sent by the external speaker. This can improve an effect of canceling fan noise (namely, the noise signal) by the first sound signal sent by the external speaker.

In another possible design manner of the first aspect, the speaker is the internal speaker. In this design manner, the internal speaker is located inside the chassis at a position close to the fan. An included angle between a sound emitting direction of the speaker and an air exhaust direction of the fan is (0, q], where q is greater than or equal to 0° and q is less than a first preset angle threshold.

It should be understood that, if the internal speaker is disposed inside the chassis at the position close to the fan, it indicates that a sound source position of the first sound signal is approximately the same as that of the first noise signal. If the sound emitting direction of the internal speaker is close to the air exhaust direction of the fan, it indicates that a main propagation direction of the first sound signal is approximately the same as that of the first noise signal. Two sound signals having a same sound source position, a same main propagation direction, and opposite phases can almost completely cancel each other.

Therefore, if the internal speaker is disposed inside the chassis at the position close to the fan and the sound emitting direction of the internal speaker is close to the air exhaust direction of the fan, the first sound signal that is sent by the internal speaker and whose phase is opposite to that of the first noise signal can almost completely cancel the first noise signal.

In another possible design manner of the first aspect, a sound source of the first sound signal may be provided by a noise database recorded in advance. Specifically, the notebook computer may prestore a plurality of rotation speeds of the fan and a reverse-phase acoustic wave corresponding to each of the rotation speeds.

Before the controlling, by the control chip, the speaker to send a first sound signal, the method in this embodiment of this application may further include: obtaining, by the control chip, a real-time rotation speed of the fan; and controlling the speaker to play a reverse-phase acoustic wave corresponding to the real-time rotation speed. The plurality of rotation speeds stored in the notebook computer include the real-time rotation speed. The reverse-phase acoustic wave corresponding to the real-time rotation speed and a noise signal of the fan under the real-time rotation speed have opposite phases and a same frequency. The reverse-phase acoustic wave corresponding to the real-time rotation speed is the first sound signal.

In another possible design manner of the first aspect, a sound source of the first sound signal may be collected by a microphone in the notebook computer in real time. Specifically, the notebook computer may further include a first microphone. The first microphone is disposed on any side of an air exhaust vent of the fan and configured to perform directional sound pickup on the fan. The method may further include: controlling, by the control chip, the first microphone to collect a second noise signal generated by running of the fan; and modulating, by the control chip, the second noise signal to obtain the first sound signal whose phase is opposite to that of the second noise signal and whose frequency is the same as that of the second noise signal.

In another possible design manner of the first aspect, the notebook computer may include not only the first microphone but also a second microphone. The second microphone is disposed on the outer side of the chassis of the notebook computer at a position close to the touchpad and configured to perform directional sound pickup on a sound signal obtained after the first sound signal cancels a noise signal generated by running of the fan.

The method in this embodiment of this application may further include: controlling, by the control chip, the first microphone to collect the second noise signal generated by the fan and the second microphone to collect a second sound signal, where the second sound signal includes a sound signal obtained after the first sound signal cancels the first noise signal; and comparing, by the control chip, the second noise signal and the second sound signal, and adjusting, based on a comparison result, the first sound signal output by the speaker so as to cancel the noise signal generated by running of the fan.

The second microphone is disposed on a housing of the base of the notebook computer at the position close to the touchpad. In other words, the second microphone is close to a position of the human ear. Therefore, the second sound signal collected by the second microphone may be considered as a sound signal heard by the human ear. In this embodiment of this application, the notebook computer may compare a real-time noise signal (namely, the second noise signal) generated by running of the fan and the second sound signal, and use the comparison result as a feedback to adjust the first sound signal output by the speaker. In this way, a fan noise cancellation effect of the notebook computer can be further improved.

It should be noted that the design manner is not only applicable to a solution in which the first microphone collects the sound source of the first sound signal in real time, but also applicable to a solution in which the noise database recorded in advance provides the sound source of the first sound signal.

In another possible design manner of the first aspect, that the first sound signal and the first noise signal have opposite phases may specifically include: a phase difference between the first sound signal and the first noise signal is [180°-p, 180°+p], where p is greater than or equal to 0° and p is less than a second preset angle threshold.

According to a second aspect, this application provides a notebook computer. The notebook computer includes a control chip, a speaker, and a fan. The control chip and the fan are disposed inside a chassis of the notebook computer. The speaker is an internal speaker disposed inside the chassis. Alternatively, the speaker is an external speaker disposed outside the chassis.

The control chip is configured to transmit a first sound signal to the speaker, where the first sound signal and a first noise signal that is generated by running of the fan have opposite phases and a same frequency. The first sound signal is used to cancel the first noise signal. The speaker is configured to send the first sound signal.

In a possible design manner of the second aspect, the speaker may be the external speaker.

The speaker is disposed in a bezel of a display of the notebook computer, and an included angle between a sound emitting direction of the speaker and a plane in which the display is located is within a first preset angle range.

The first preset angle range is determined based on statistics of a large number of users using the notebook computer about included angles between a first direction and the plane in which the display is located. The first direction is parallel to a connection line between a position of the speaker and an ear of the user when the user is using the notebook computer.

In another possible design manner of the second aspect, the speaker may be the external speaker.

The speaker is disposed in a base of the notebook computer at a position close to a keyboard or touchpad of the notebook, and an included angle between a sound emitting direction of the speaker and a plane in which the keyboard or the touchpad is located is within a second preset angle range.

The second preset angle range is determined based on statistics of a large number of users using the notebook computer about included angles between a second direction and the plane in which the keyboard or the touchpad is located. The second direction is parallel to a connection line between the position of the speaker and an ear of the user when the user is using the notebook computer.

In another possible design manner of the second aspect, the speaker may be the internal speaker, and the internal speaker is located inside the chassis at a position close to the fan. An included angle between a sound emitting direction of the speaker and an air exhaust direction of the fan is (0, q], where q is greater than or equal to 0° and q is less than a first preset angle threshold.

In another possible design manner of the second aspect, the control chip is further configured to obtain a real-time rotation speed of the fan, and obtain a reverse-phase acoustic wave corresponding to the real-time rotation speed, where the reverse-phase acoustic wave corresponding to the real-time rotation speed and a noise signal of the fan under the real-time rotation speed have opposite phases and a same frequency, and the reverse-phase acoustic wave corresponding to the real-time rotation speed is the first sound signal.

The notebook computer prestores a plurality of rotation speeds of the fan and a reverse-phase acoustic wave corresponding to each of the rotation speeds. The plurality of rotation speeds include the real-time rotation speed.

In another possible design manner of the second aspect, the notebook computer further includes a first microphone and a second microphone. The first microphone is disposed on any side of an air exhaust vent of the fan and configured to perform directional sound pickup on the fan. The second microphone is disposed on the outer side of the chassis of the notebook computer at a position close to the touchpad and configured to perform directional sound pickup on a sound signal obtained after the first sound signal cancels a noise signal generated by running of the fan.

The control chip is further configured to instruct the first microphone and the second microphone to collect sound signals. The first microphone is configured to collect, in response to an instruction of the control chip, a second noise signal generated by the fan. The second microphone is configured to collect a second sound signal in response to an instruction of the control chip, where the second sound signal includes a sound signal obtained after the first sound signal cancels the first noise signal. The control chip is further configured to compare the second noise signal and the second sound signal, and adjust, based on a comparison result, the first sound signal output by the speaker so as to cancel the noise signal generated by running of the fan.

In another possible design manner of the second aspect, the notebook computer further includes a first microphone. The first microphone is disposed on any side of an air exhaust vent of the fan and configured to perform directional sound pickup on the fan. The control chip is further configured to instruct the first microphone to collect a sound signal. The first microphone is configured to collect, in response to an instruction of the control chip, a second noise signal generated by the fan. The control chip is further configured to modulate the second noise signal to obtain the first sound signal whose phase is opposite to that of the second noise signal and whose frequency is the same as that of the second noise signal.

In another possible design manner of the second aspect, the notebook computer further includes a second microphone. The second microphone is disposed on the outer side of the chassis of the notebook computer at a position close to the touchpad and configured to perform directional sound pickup on a sound signal obtained after the first sound signal cancels a noise signal generated by running of the fan.

The control chip is further configured to instruct the second microphone to collect a sound signal. The second microphone is configured to collect a second sound signal in response to an instruction of the control chip, where the second sound signal includes a sound signal obtained after the first sound signal cancels the first noise signal. The control chip is further configured to compare the second noise signal and the second sound signal, and adjust, based on a comparison result, the first sound signal output by the speaker so as to cancel the noise signal generated by running of the fan.

In another possible design manner of the second aspect, that the first sound signal and the first noise signal have opposite phases includes: a phase difference between the first sound signal and the first noise signal is [180°-p, 180°+p], where p is greater than or equal to 0° and p is less than a second preset angle threshold.

According to a third aspect, this application provides a chip system. The chip system may be the control chip in any one of the first aspect, the second aspect, or the possible design manners thereof. The chip system may be applied to a notebook computer that includes a fan, a speaker, a microphone, and a memory. The system-on-chip includes one or more interface circuits and one or more processors. The interface circuit and the processor are interconnected by a line. The interface circuit is configured to receive signals from the memory and send the signals to the processor, where the signals include computer instructions stored in the memory. When the processor executes the computer instructions, the notebook computer performs the method described in the first aspect and any possible design of the first aspect.

According to a fourth aspect, this application provides a computer-readable storage medium. The computer-readable storage medium includes computer instructions. When the computer instructions are run on a notebook computer, the notebook computer is enabled to perform the method according to any one of the first aspect or the possible design manners of the first aspect.

According to a fifth aspect, this application provides a computer program product. When the computer program product is run on a computer, the computer is enabled to perform the method described in the first aspect and any possible design of the first aspect.

It may be understood that, for beneficial effects that can be achieved by the notebook computer described in the second aspect and any possible design of the second aspect, the system-on-chip described in the third aspect, the computer-readable storage medium described in the fourth aspect, and the computer program product described in the fifth aspect, reference may be made to the beneficial effects in the first aspect and any possible design of the first aspect. Details are not described herein again.

### BRIEF DESCRIPTION OF DRAWINGS

FIG. 1 is a schematic diagram of a product form of a notebook computer according to an embodiment of this application;
FIG. 2 is a schematic diagram of a principle of fan noise cancellation according to an embodiment of this application;
FIG. 3 is a schematic diagram of a hardware structure of a notebook computer according to an embodiment of this application;
FIG. 4 is a schematic diagram of a product form of a notebook computer according to an embodiment of this application;
FIG. 5 is a schematic diagram of disassembly of a base of a notebook computer according to an embodiment of this application;
FIG. 6 is a schematic diagram of a principle of fan noise cancellation according to an embodiment of this application;
FIG. 7 is a schematic diagram of a product form of a notebook computer according to an embodiment of this application;
FIG. 8 is a schematic diagram of disassembly of a base of a notebook computer according to an embodiment of this application;
FIG. 9 is a schematic diagram of a principle of fan noise cancellation according to an embodiment of this application;
FIG. 10 is a flowchart of a fan noise reduction method for a notebook computer according to an embodiment of this application; and
FIG. 11 is a schematic diagram of a structure of a system-on-chip of a notebook computer according to an embodiment of this application.

### DESCRIPTION OF EMBODIMENTS

Hereinafter, the terms "first" and "second" are intended only for description, and shall not be understood as an indication or implication of relative importance or an implicit indication of a quantity of indicated technical features. Therefore, a feature defined by "first" or "second" may explicitly or implicitly include one or more features. In the description of the embodiments, "a plurality of" means at least two, unless otherwise specified.

An embodiment of this application provides a fan noise reduction method for a notebook computer. The method can be applied to a notebook computer. The notebook computer includes a fan used for heat dissipation and a speaker.

It should be understood that heat is generated in a running process of the notebook computer, which causes an increase in hardware temperature of the notebook computer. If the hardware temperature of the notebook computer is excessively high, components of the notebook computer may be damaged. Therefore, the fan needs to run to dissipate heat for the notebook computer. However, running of the fan may generate noise (referred to as a noise signal, such as a first noise signal).

In this solution, the notebook computer may control the speaker to send a first sound signal (namely, a reverse-phase acoustic wave) whose phase is opposite to that of the first noise signal and whose frequency is the same as that of the first noise signal, to cancel the noise signal. In this way, fan noise heard by a user can be reduced, thereby resolving a conflict between heat dissipation by the fan and fan noise, and improving user experience of the notebook computer.

That the first sound signal and the first noise signal have opposite phases specifically means that a phase difference between the first sound signal and the first noise signal is approximately 180°.

A notebook computer provided in the embodiments of this application includes a fan configured to dissipate heat for the notebook computer and one or more speakers (also referred to as a loudspeaker). The fan may be disposed inside a chassis of the notebook computer. The speaker may be disposed inside the chassis of the notebook computer or on the outer side of the chassis.

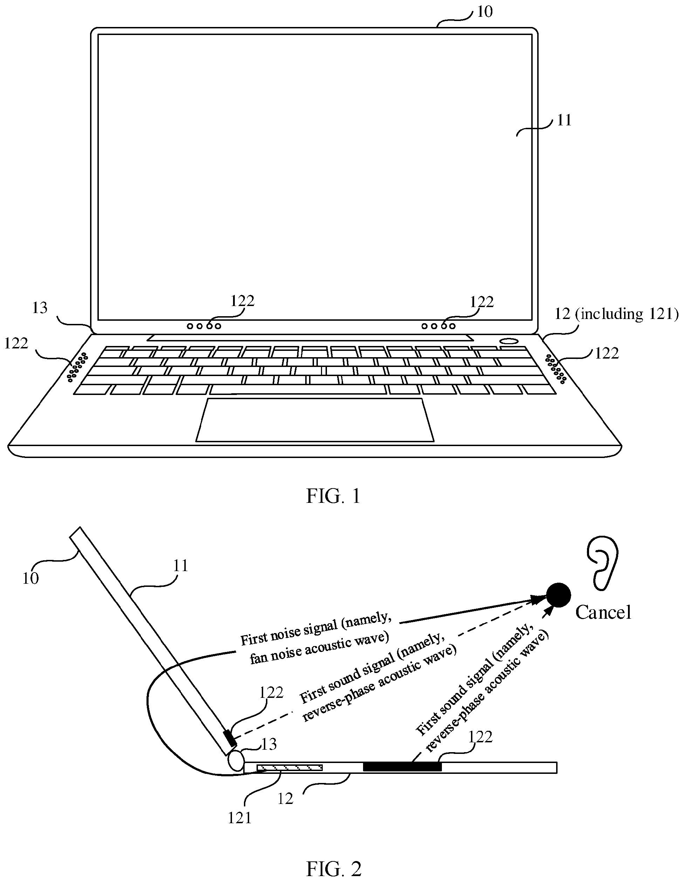

For example, FIG. 1 is a schematic diagram of a product form of a notebook computer 10 according to an embodiment of this application. As shown in FIG. 1, the notebook computer 10 includes a display 11, a base 12, and a rotating shaft 13 configured to connect the display 11 and the base 12. The notebook computer 10 may include a fan 121 used for heat dissipation and one or more speakers 122.

The fan 121 may be disposed inside the base 12 of the notebook computer 10 shown in FIG. 1. The base 2 of the notebook computer 10 is included in a chassis of the notebook computer 10 shown in FIG. 1. The speaker 122 may be disposed inside the chassis of the notebook computer 10 or on the outer side of the chassis. For example, the speaker 122 is disposed on the outer side of the chassis of the notebook computer 10. As shown in FIG. 1, speakers 122 are disposed on the left and right sides of a keyboard on the base 12, and/or speakers 122 are disposed below the display 11.

Running of the fan 121 shown in FIG. 1 may generate a noise signal (such as a first noise signal). The speaker 122 shown in FIG. 1 can send a first sound signal (namely, a reverse-phase acoustic wave) whose phase is opposite to that of the first noise signal and whose frequency is the same as that of the first noise signal, to cancel the first noise signal. In this way, fan noise heard by a user can be reduced.

With the notebook computer 10 as an example, FIG. 2 is a schematic diagram of an application scenario of a fan noise reduction method for a notebook computer according to an embodiment of this application.

When a user is using the notebook computer 10, the notebook computer 10 may be in a state shown in FIG. 2. When the user is using the notebook computer 10, running of the fan 12 of the notebook computer 10 may generate a first noise signal (namely, a fan noise acoustic wave). As shown in FIG. 2, the first noise signal propagated through a medium (such as air) can be heard by the user, which affects user experience. According to this solution, the speaker 122 can send a first sound signal (namely, a reverse-phase acoustic wave of the first noise signal), where the first sound signal can also be propagated through the medium (such as air). Because the first sound signal and the first noise signal have opposite phases, the first sound signal can be used to cancel the first noise signal in a sound signal propagation process. In this way, fan noise heard by the user can be reduced, thereby improving user experience of the notebook computer 10.

The fan 12 is represented by a slash-filled rectangular block in FIG. 2, and the speaker 122 is represented by a black-filled rectangular block in FIG. 2. It should be noted that the fan 12 and the speaker 122 are not disposed on the left side face of a housing of the chassis of the notebook computer 10. The fan 12 is disposed inside the chassis of the notebook computer 10. From the appearance of the notebook computer 10, the fan 12 is invisible to the user. As shown in FIG. 2, the speaker 122 is disposed on one side of the keyboard of the notebook computer 10 in a plane in which the keyboard is located, or the speaker 122 is disposed in a lower bezel of the display of the notebook computer 10. Although the speaker 122 is disposed on the housing of the chassis of the notebook computer 10, the speaker 122 may also be invisible to the user when the appearance of the notebook computer 10 is observed from the left side face of the notebook computer 10.

It should be noted that a hardware structure of the notebook computer provided in the embodiments of this application and positions of components of the notebook computer include but are not limited to the structure and positions shown in FIG. 1 and FIG. 2. FIG. 1 and FIG. 2 show merely an example of a possible product form of the notebook computer in the embodiments of this application. For detailed descriptions of the notebook computer provided in the embodiments of this application, refer to related descriptions in the following embodiments.

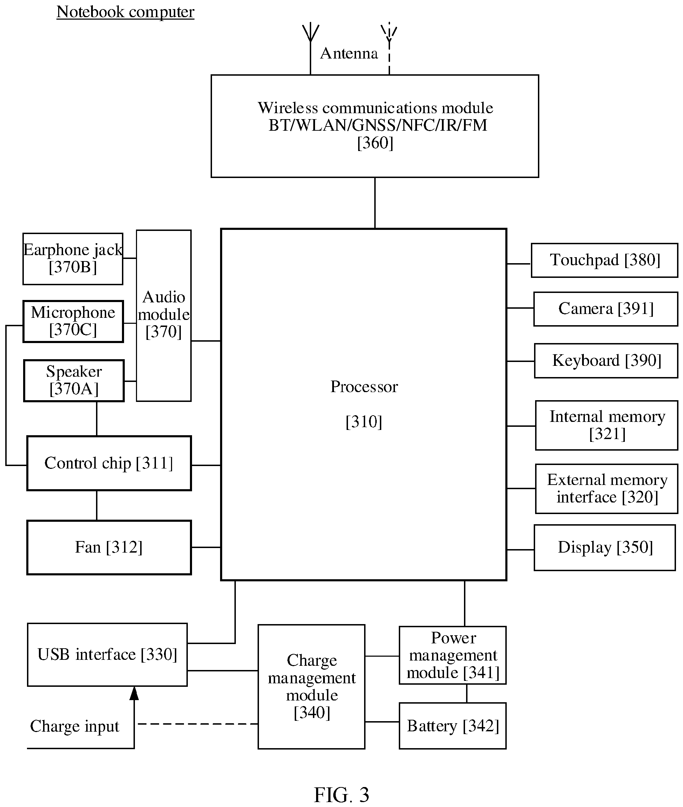

FIG. 3 is a schematic diagram of a structure of a notebook computer according to an embodiment of this application. As shown in FIG. 3, the notebook computer may include a processor 310, a control chip 311, a fan 312, an external memory interface 320, an internal memory 321, a universal serial bus (universal serial bus, USB) interface 330, a charge management module 340, a power management module 341, a battery 342, a display 350, an antenna, a wireless communications module 360, an audio module 370, a speaker (namely, a loudspeaker) 370A, a microphone 170C, a earphone jack 370B, a touchpad 380, a keyboard 390, a camera 391, and the like.

All of the components other than the display 350 (such as the processor 310, the control chip 311, the fan 312, the external memory interface 320, the internal memory 321, the USB interface 330, the charge management module 340, the power management module 341, the battery 342, the antenna, the wireless communications module 360, the audio module 370, the touchpad 380, the speaker 370A, the microphone 170C, the earphone jack 370B, the keyboard 390, and the camera 391) may be disposed in a base of the notebook computer. The camera 391 may be disposed in the base of the notebook computer or a bezel of the display 350.

It should be understood that a structure illustrated in this embodiment of this application does not constitute a specific limitation on the notebook computer. In some other embodiments, the notebook computer may include more or fewer components than those shown in the figure, or combine some components, or split some components, or have different component arrangements. The components shown in the figure may be implemented in hardware, software, or a combination of software and hardware.

The processor 310 may include one or more processing units. For example, the processor 310 may include an application processor (application processor, AP), a modem processor, a graphics processing unit (graphics processing unit, GPU), an image signal processor (image signal processor, ISP), a controller, a memory, a video codec, a digital signal processor

(digital signal processor, DSP), a baseband processor, and/or a neural-network processing unit (neural-network processing unit, NPU). Different processing units may be separate components or integrated in one or more processors.

A controller may be a nerve center and command center of the notebook computer. The controller may generate an operation control signal according to an instruction operation code and a timing signal to complete control of instruction fetching and execution.

A memory may be further disposed in the processor 310 and is configured to store an instruction and data. In some embodiments, the memory in the processor 310 is a cache memory. The memory may store an instruction or data that has just been used or cyclically used by the processor 310. If the processor 310 needs to use the instruction or data again, the processor 310 may invoke the instruction or data directly from the memory. Therefore, repeated access is avoided, a waiting time of the processor 310 is reduced, and efficiency of the system is improved.

In some embodiments, the processor 310 may include one or more interfaces. The interface may include an integrated circuit (inter-integrated circuit, I2C) interface, an integrated circuit built-in audio (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, and/or a universal serial bus (universal serial bus, USB) interface, or the like.

It can be understood that an interface connection relationship between the modules shown in this embodiment is merely an example for description, and does not constitute any limitation on the structure of the notebook computer. In some other embodiments, the notebook computer may alternatively use an interface connection manner different from those in the foregoing embodiment or a combination of a plurality of interface connection manners.

The charge management module 340 is configured to receive a charge input from a charger (such as a wireless charger or a wired charger) to charge the battery 342. The power management module 341 is configured to connect the battery 342, the charge management module 340, and the processor 310. The power management module 341 receives an input from the battery 342 and/or the charge management module 340 to supply power to the components of the notebook computer.

A wireless communication function of the notebook computer may be implemented by using the antenna, the wireless communications module 360, the modem processor, the baseband processor, and the like.

Antennas are configured to transmit and receive electromagnetic wave signals. Each antenna in the notebook computer may be configured to cover one or more communications frequency bands. In addition, different antennas may be multiplexed to improve utilization of the antennas.

In some embodiments, the antenna of the notebook computer is coupled to the wireless communications module 360, so that the notebook computer can communicate with a network and another device by using a wireless communications technology. The wireless communications module 360 may provide a wireless communications solution applied to the notebook computer and including a wireless local area network (wireless local area networks, WLAN) (for example, a Wireless Fidelity (wireless fidelity, Wi-Fi) network), Bluetooth (bluetooth, BT), a global navigation satellite system (global navigation satellite system, GNSS), frequency modulation (frequency modulation, FM), a near field communication (near field communication, NFC) technology, an infrared (infrared, IR) technology, and the like.

The notebook computer can implement a display function by using the GPU, the display 350, the application processor, and the like. The GPU is a microprocessor used for image processing, and is connected to the display screen 350 and the application processor. The GPU is configured to perform mathematical and geometric computation for graphic rendering. The processor 310 may include one or more GPUs, and the GPU executes a program instruction to generate or change display information. The display screen 350 is configured to display an image, a video, and the like.

A touch sensor is integrated into the touch panel 380. Anotebook computer may receive a control command of a user for the notebook computer through the touch panel 380 and the keyboard 390.

The notebook computer may implement the shooting function by using the ISP, the camera 391, the video codec, the GPU, the display 350, the application processor, and the like. The ISP is configured to process data fed back by the camera 391. In some embodiments, the ISP may be disposed in the camera 391. The camera 391 is configured to capture still images or videos. In some embodiments, the notebook computer may include one or N cameras 391, where N is a positive integer greater than 1.

The external memory interface 320 may be configured to connect to an external memory card, for example, a Micro SD card, to extend a storage capability of the notebook computer. The internal memory 321 may be configured to store computer-executable program code, where the computer-executable program code includes instructions. The processor 310 performs various function applications and data processing of the notebook computer by running the instructions stored in the internal memory 321. For example, in this embodiment of this application, the processor 310 may execute the instructions stored in the internal memory 321. The internal memory 321 may include a program storage area and a data storage area.

The notebook computer can implement an audio function by using the audio module 370, the speaker 370A, the microphone 170C, the earphone jack 370B, the application processor, and the like. For example, music playback and sound recording.

The audio module 370 is configured to convert digital audio information into an analog audio signal for outputting, and also configured to convert an analog audio input into a digital audio signal. The audio module 370 may be further configured to encode and decode an audio signal. In some embodiments, the audio module 370 may be provided in the processor 310, or some functional modules of the audio module 370 may be provided in the processor 310. The speaker 370A, also referred to as a "loudspeaker", is configured to convert an audio electrical signal into a sound signal. The microphone 370C, also referred to as a "mic" or a "mike", is configured to convert a sound signal into an electrical signal. The earphone jack 370B is configured to connect wired earphones. The earphone jack 370B may be the USB interface 330, or may be a 3.5 mm open mobile terminal platform (open mobile terminal platform, OMTP) standard interface, or a cellular telecommunications industry association of the USA (cellular telecommunications industry association of the USA, CTIA) standard interface.

The notebook computer in this embodiment of this application may include one or more speakers 370A and one or more microphones 370C. For example, the speaker 370A may be the speaker 122 shown in FIG. 1. The microphones 370C may include a first microphone and second microphone described in the embodiments of this application.

The fan 312 is configured to dissipate heat for the notebook computer. The processor 310 may control the fan 312 to run at different rotation speeds to dissipate heat for the notebook computer. Running of the fan 312 generates a first noise signal. The control chip 311 is configured to detect whether the fan 312 is running, and may further detect a real-time rotation speed of the fan 312. The control chip 311 may further control the speaker 370A to send a first sound signal to cancel the first noise signal.

All methods in the following embodiments can be implemented in a notebook computer having the foregoing hardware structure. A notebook computer provided in the embodiments of this application and a fan noise reduction method for the notebook computer are described in detail herein in the embodiments of this application.

An embodiment of this application provides a notebook computer 400. The notebook computer 400 includes a control chip 40a, a fan 40b used for heat dissipation, and a speaker 42.

The control chip 40a and the fan 40b may be disposed inside a chassis of the notebook computer 400. The speaker 42 may be an internal speaker, and the internal speaker may be disposed inside the chassis of the notebook computer 400. Alternatively, the speaker 42 may be an external speaker, and the external speaker may be disposed outside the chassis of the notebook computer 400. For positions of the components of the notebook computer 400 in the notebook computer 400, refer to detailed descriptions in the following embodiments. Details are not described herein.

It should be understood that, in a running process of the notebook computer 400, the fan 40b may be controlled to run to dissipate heat for the notebook computer. For example, a processor of the notebook computer 400 may control the fan 40b to run to dissipate heat for the notebook computer. Running of the fan 40b may generate a first noise signal.

In this embodiment of this application, the control chip 40a may control the speaker 42 to send a first sound signal whose phase is opposite to that of the first noise signal generated by running of the fan 40b and whose frequency is the same as that of the first noise signal.

The control chip 40a may control, when the fan 40b is running, the speaker 42 to send the first sound signal. For example, the control chip 40a may detect whether the fan 40b is running. If it is detected that the fan 40b is running, the control chip 40a controls the speaker 42 to send the first sound signal. The control chip 40a is connected to the fan 40b. For example, the control chip 40a may be connected to an engine of the fan 40b so as to detect whether the fan 40b is in a running state or a stopped state. In this embodiment of this application, when the fan 40b is in the running state, a rotation speed of the fan 40b is greater than a preset rotation speed threshold; when the fan 40b is in the running state, a rotation speed of the fan 40b is less than or equal to the preset rotation speed threshold. It should be noted that the detecting, by the control chip 40a, whether the fan 40b is running is optional.

For example, the control chip 40a may send a first control instruction to the speaker 42 after the fan 40b stops running. The first control instruction is used to instruct the speaker 42 to send the first sound signal.

The first sound signal and the first noise signal have opposite phases. It can be understood that, for an acoustic wave (namely, a sound signal), a phase (phase) is a location (for example, a peak, a trough, or a point between a peak and a trough) of the acoustic wave in a waveform of the acoustic wave at a specific moment. The phase may be considered as a scale indicating that the acoustic wave is at the peak, the trough, or the point between the peak and the trough at the specific moment. For example, at a specific moment, when the first noise signal is at a peak, the first sound signal is at a trough; or when the first noise signal is at a trough, the first sound signal is at a peak.

In addition, for two acoustic waves whose sound sources are the same or different, if parameters such as amplitudes and frequencies at a same moment are the same but phases of the two acoustic waves are opposite, the two acoustic waves can cancel each other in a propagation process.

In this embodiment of this application, that the first sound signal and the first noise signal have opposite phases may specifically include: a phase difference between the first sound signal and the first noise signal is [180°-p, 180°+p], where p is greater than or equal to 0° and p is less than a second preset angle threshold. For example, the second preset angle threshold may be a value greater than 0° and close to 0°, such as 3°, 5°, 6°, or 2°.

In this solution, the notebook computer 400 may control the speaker 42 to send the first sound signal (namely, a reverse-phase acoustic wave) whose phase is opposite to that of the first noise signal and whose frequency is the same as that of the first noise signal, to cancel the first noise signal. In this way, fan noise heard by a user can be reduced when the fan 40b is running to dissipate heat for the notebook computer 400. This can resolve a conflict between heat dissipation by the fan and fan noise, and improve user experience of the notebook computer.

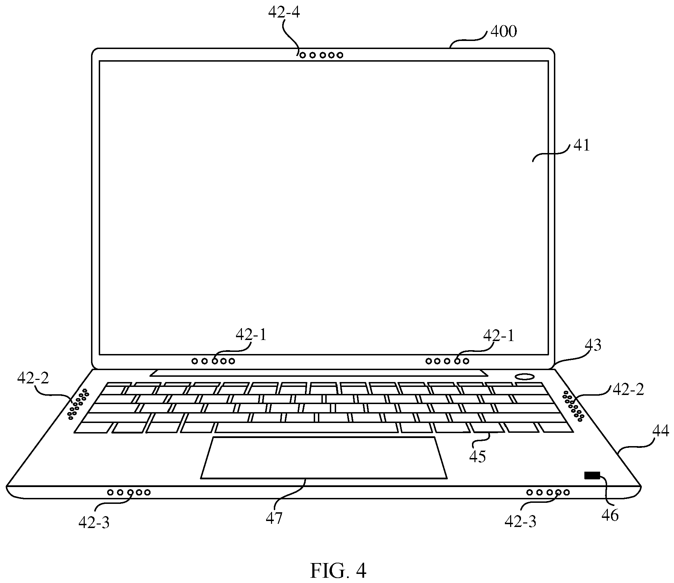

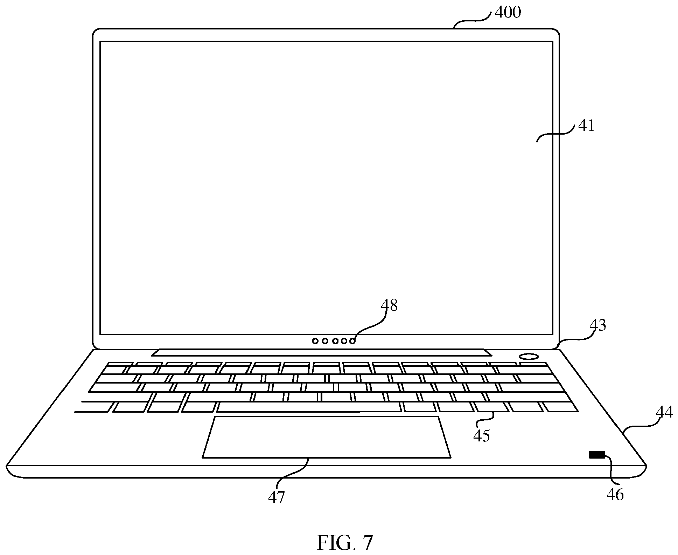

For example, as shown in FIG. 4 or FIG. 7, the notebook computer 400 may further include components such as a display 41, a base 44, a rotating shaft 43 configured to connect the display 41 and the base 44, a keyboard 45, and a touchpad 47. Both a housing configured to fasten the display 41 and the base 44 may be referred to as a chassis of the notebook computer 400. Certainly, components of the notebook computer 400 include but are not limited to the various components shown in FIG. 4 or FIG. 7.

In a first implementation of this embodiment of this application, the speaker 42 is an external speaker, where the external speaker is disposed outside the chassis of the notebook computer 400; and the control chip 40a and the fan 40b are disposed inside the chassis of the notebook computer 400.

That the speaker 42 is an external speaker disposed outside the chassis of the notebook computer 400 may include at least the following two cases: a case (1) and a case (2).

Case (1): The speaker 42 may be disposed in the base 44 of the notebook computer 400.

For example, the speaker 42 may include external speakers 42-2 shown in FIG. 4. The speaker 42 may be disposed at a position close to the keyboard 45 in a face on which the keyboard 45 and the touchpad 47 are located on the base 44. The external speakers 42-2 shown in FIG. 4 are disposed in the face on which the keyboard 45 is located on the base 44, and are located on the left and right sides of the keyboard 45.

For another example, the speaker 42 may be alternatively disposed at a position close to the touchpad 47 in a face on which the keyboard 45 and the touchpad 47 are located on the base 44 (not shown in the figure).

For another example, the speaker 42 may include external speakers 42-3 shown in FIG. 4. The external speakers 42-3 shown in FIG. 4 are disposed in a side face of the base 44 close to the touchpad 47.

In some embodiments, the speaker 42 may include a plurality of speakers disposed at different positions on the base 44. For example, the speaker 42 may include the external speakers 42-2 and the external speakers 42-3.

Case (2): The speaker 42 may be disposed in a bezel of the display 41 of the notebook computer 400.

For example, the speaker 42 may be disposed in an upper bezel of the display 41. The speaker 42 may include an external speaker 42-4 shown in FIG. 4. The external speaker 42-4 is disposed in the upper bezel of the display 41.

For another example, the speaker 42 may be disposed in a lower bezel of the display 41. The speaker 42 may include external speakers 42-1 shown in FIG. 4. The external speakers 42-1 are disposed in the lower bezel of the display 41.

In some embodiments, the speaker 42 may include a plurality of speakers disposed at different positions on the bezel of the display 41. For example, the speaker 42 may include the external speakers 42-1 and the external speaker 42-4.

In some other embodiments, the speaker 42 may include not only a speaker disposed in the bezel of the display 41 but also a speaker disposed in the base 44. For example, the speaker 42 may include the external speakers 42-1, the external speakers 42-2, and the external speakers 42-3.

It should be noted that the external speaker may be a speaker provided by the notebook computer 400 and configured to play an audio signal or a sound signal. Alternatively, the external speaker may be a speaker added to the notebook computer 400 to implement the method in the embodiments of this application.

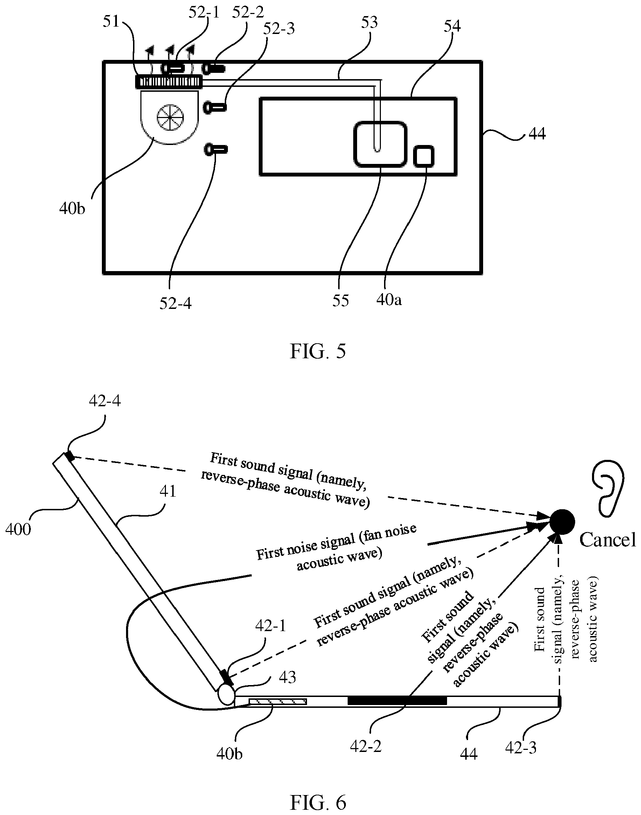

In the foregoing first implementation, the control chip 40a and the fan 40b are disposed inside the base 44 of the notebook computer 400. For example, FIG. 5 is a schematic diagram of disassembly of the base 44 of the notebook computer 400 shown in FIG. 4.

As shown in FIG. 5, the control chip 40a and the fan 40b are both disposed inside the base 44 of the notebook computer 400. As shown in FIG. 5, the base 44 is further provided with a heat dissipation fin 51, a heat pipe 53, a PCB board 54, and a processor (such as a CPU) 55.

The control chip 40a and the processor 55 are fastened to the PCB board 54. The processor 55 is connected to the heat dissipation fin 51 via the heat pipe 53. The fan 40b is disposed on one side of the heat dissipation fin 51. Running of the fan 40b can reduce temperature of the heat dissipation fin 51, to dissipate heat for the processor 55 via the heat pipe 53.

With the notebook computer 400 shown in FIG. 4 as an example, FIG. 6 is a schematic diagram of an application scenario of a fan noise reduction method for a notebook computer according to an embodiment of this application.

When a user is using the notebook computer 400, the notebook computer 400 may be in a state shown in FIG. 6. When the user is using the notebook computer 400, running of the fan 40b of the notebook computer 400 may generate a first noise signal (namely, a fan noise acoustic wave). As shown in FIG. 6, the first noise signal propagated through a medium (such as air) can be heard by the user, which affects user experience. According to this solution, at least one of the external speakers 42-1, the external speakers 42-2, the external speakers 42-3, or the external speaker 42-4 can send a first sound signal, where the first sound signal can also be propagated through the medium (such as air). Because the first sound signal and the first noise signal have opposite phases, the first sound signal can be used to cancel the first noise signal in a sound signal propagation process. In this way, fan noise heard by the user can be reduced, thereby improving user experience of the notebook computer 400.

To improve an effect of canceling fan noise (namely, the noise signal) by a reverse-phase acoustic wave (namely, the first sound signal) sent by the external speaker, in this embodiment of this application, an orientation of the external speaker (such as the external speakers 42-2 and/or the external speakers 42-3) may be set, so that a sound emitting direction of the external speaker is parallel to a connection line between the external speaker and a human ear.

In the case (1), the external speaker is disposed in the base of the notebook computer 400. In this case, an included angle between the sound emitting direction of the external speaker and a plane in which the keyboard 45 or the touchpad 47 is located is within a second preset angle range.

The second preset angle range is determined based on statistics of a large number of users using the notebook computer 400 about included angles between a second direction and the plane in which the keyboard 45 or the touchpad 47 is located. The second direction is parallel to a connection line between a position of the external speaker and an ear of the user when the user is using the notebook computer 400.

For example, the speaker 42 includes the external speakers 42-2. The second direction is parallel to a connection line between the external speaker 42-2 and the human ear shown in FIG. 6. A sound emitting direction of the external speaker 42-2 is parallel to the connection line between the external speaker 42-2 and the human ear shown in FIG. 6, so that the human ear can better receive the first sound signal sent by the external speaker 42-2. This can improve an effect of canceling fan noise (namely, the noise signal) by the first sound signal sent by the external speaker 42-2.

For another example, the speaker 42 includes the external speakers 42-3. The second direction is parallel to a connection line between the external speaker 42-3 and the human ear shown in FIG. 6. A sound emitting direction of the external speaker 42-3 is parallel to the connection line between the external speaker 42-3 and the human ear shown in FIG. 6, so that the human ear can better receive the first sound signal sent by the external speaker 42-3. This can improve an effect of canceling fan noise (namely, the noise signal) by the first sound signal sent by the external speaker 42-3.

In the case (2), the external speaker is disposed in the bezel of the display of the notebook computer 400. In this case, an included angle between the sound emitting direction of the external speaker and a plane in which the display 41 is located is within a first preset angle range.

The first preset angle range is determined based on statistics of a large number of users using the notebook computer 400 about included angles between a first direction and the plane in which the display 41 is located. The first direction is parallel to a connection line between a position of the external speaker and an ear of the user when the user is using the notebook computer 400.

For example, the speaker 42 includes the external speakers 42-1. The first direction is parallel to a connection line between the external speaker 42-1 and the human ear shown in FIG. 6. A sound emitting direction of the external speaker 42-1 is parallel to the connection line between the external speaker 42-1 and the human ear shown in FIG. 6, so that the human ear can better receive the first sound signal sent by the external speaker 42-1. This can improve an effect of canceling fan noise (namely, the noise signal) by the first sound signal sent by the external speaker 42-1.

For another example, the speaker 42 includes the external speaker 42-4. The first direction is parallel to a connection line between the external speaker 42-4 and the human ear shown in FIG. 6. A sound emitting direction of the external speaker 42-4 is parallel to the connection line between the external speaker 42-4 and the human ear shown in FIG. 6, so that the human ear can better receive the first sound signal sent by the external speaker 42-4. This can improve an effect of canceling fan noise (namely, the noise signal) by the first sound signal sent by the external speaker 42-4.

In a second implementation of this embodiment of this application, the speaker 42 is an internal speaker, where the internal speaker is disposed inside the chassis of the notebook computer 400; and the control chip 40a and the fan 40b are disposed inside the chassis of the notebook computer 400.

That the speaker 42 is an internal speaker disposed inside the chassis of the notebook computer 400 may be specifically: the internal speaker is disposed inside the chassis at a position close to the fan 40b.

In the second implementation, as shown in FIG. 7, the internal speaker is invisible to the user from the appearance of the notebook computer 400. It should be noted that the speaker 42 being the internal speaker does not mean that the notebook computer 400 includes no external speaker. The notebook computer may include the internal speaker configured to cancel fan noise, and may further include an external speaker (such as an external speaker 48 shown in FIG. 7) configured to play an audio signal or a sound signal.

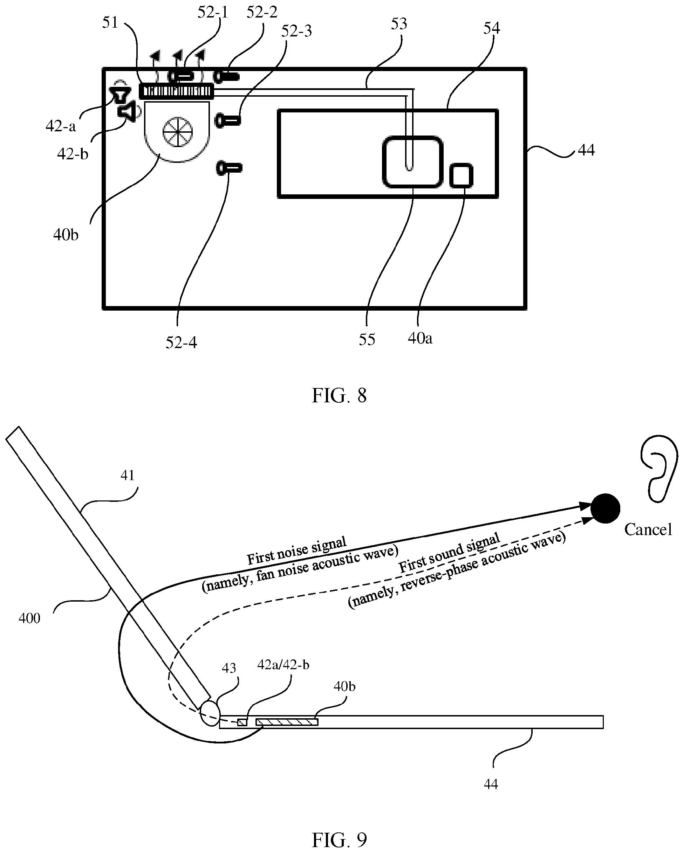

FIG. 8 is a schematic diagram of disassembly of the base 44 of the notebook computer 400 shown in FIG. 7. As shown in FIG. 7, the base 44 is not only provided with the components such as the control chip 40a, the fan 40b, the heat dissipation fin 51, the heat pipe 53, the PCB board 54, and the processor 55 shown in FIG. 5, but also provided with an internal speaker, such as an internal speaker 42-a and/or an internal speaker 42-b. The internal speaker 42-a and the internal speaker 42-b are both disposed inside the chassis at positions close to the fan 40b.

To improve an effect of canceling fan noise (namely, the noise signal) by a reverse-phase acoustic wave (namely, the first sound signal) sent by the internal speaker, in this embodiment of this application, an orientation of the internal speaker (such as the internal speaker 42-a and/or the internal speaker 42-b) may be set, so that a sound emitting direction of the internal speaker is close to an air exhaust direction of the fan 40b.

It should be understood that, if the internal speaker is disposed inside the chassis at the position close to the fan 40b, it indicates that a sound source position of the first sound signal is approximately the same as that of the first noise signal. If the sound emitting direction of the internal speaker is close to the air exhaust direction of the fan 40b, it indicates that a main propagation direction of the first sound signal is approximately the same as that of the first noise signal. Two sound signals having a same sound source position, a same main propagation direction, and opposite phases can almost completely cancel each other.

Therefore, if the internal speaker is disposed inside the chassis at the position close to the fan 40b and the sound emitting direction of the internal speaker is close to the air exhaust direction of the fan 40b, the first sound signal that is sent by the internal speaker and whose phase is opposite to that of the first noise signal can almost completely cancel the first noise signal.

Specifically, in this embodiment of this application, an included angle between the sound emitting direction of the internal speaker and the air exhaust direction of the fan 40b is (0, q], where q is greater than or equal to 0° and q is less than a first preset angle threshold. For example, the first preset angle threshold may be any angle such as 10°, 5°, or 6°.

In this embodiment of this application, the internal speaker is disposed inside the chassis at the position close to the fan 40b and the sound emitting direction of the internal speaker is set to be close to the air exhaust direction of the fan 40b, so that an effect of canceling fan noise by the first sound signal can be optimized to a greater extent.

With the notebook computer 400 shown in FIG. 7 as an example, FIG. 9 is a schematic diagram of an application scenario of a fan noise reduction method for a notebook computer according to an embodiment of this application.

When a user is using the notebook computer 400, the notebook computer 400 may be in a state shown in FIG. 9. When the user is using the notebook computer 400, running of the fan 40b of the notebook computer 400 may generate a first noise signal (namely, a fan noise acoustic wave). As shown in FIG. 9, the first noise signal propagated through a medium (such as air) can be heard by the user, which affects user experience. According to this solution, at least one of the internal speaker 42-a or the internal speaker 42-b can send a first sound signal, where the first sound signal can also be propagated through the medium (such as air). Because the first sound signal and the first noise signal have opposite phases, the first sound signal can be used to cancel the first noise signal in a sound signal propagation process. In this way, fan noise heard by the user can be reduced, thereby improving user experience of the notebook computer 400.

It can be learned from the foregoing embodiments that the speaker 42 may be the internal speaker or may be the external speaker. Regardless of whether the speaker 42 is the internal speaker or the external speaker, a process from when the speaker 43 sends the first sound signal to when the first sound signal is heard by the user takes a specific time, which is denoted by Δt3. A process from when the fan 40b sends the first noise signal to when the speaker 43 sends the first sound signal also takes a specific time, which is denoted by Δt2, where Δt2 is a processing time of the first sound signal. A process from when the fan 40b sends the first noise signal to when the first noise signal is heard by the user also takes a specific time, which is denoted by Δt1, where Δt1=Δt2+Δt3.

Compared with the internal speaker, the external speaker is at a shorter distance from the human ear. Therefore, compared with that of the internal speaker, the time (namely, Δt3) for the first sound signal sent by the external speaker to be propagated to the human ear is shorter. When Δt1 remains unchanged, if Δt3 is smaller, Δt2 may be larger. In other words, compared with using the internal speaker, using the external speaker can reserve more time for the control chip 40a to perform signal processing to obtain the first sound signal. Therefore, in this embodiment of this application, compared with using the internal speaker to cancel fan noise, using the internal speaker to cancel fan noise is more recommended.

In some embodiments, a sound source of the first sound signal may be provided by a noise database recorded in advance. Specifically, the notebook computer 400 may store a plurality of rotation speeds of the fan 40b and a noise signal of the fan 40b under each of the rotation speeds. For example, the plurality of rotation speeds of the fan 40b and the noise signal of the fan 40b under each of the rotation speeds may be stored in the control chip 40a of the notebook computer 400; or the plurality of rotation speeds of the fan 40b and the noise signal of the fan 40b under each of the rotation speeds may be stored in a memory of the notebook computer 400.

The plurality of rotation speeds of the fan 40b and the noise signal of the fan 40b under each of the rotation speeds may be collected and configured in the notebook computer 400 before delivery of the notebook computer 400.

For example, one or more microphones may be placed around the fan 40b of the notebook computer 400. Then, the fan 40b of the notebook computer 400 may be controlled to run at different rotation speeds, and the one or more microphones are controlled to collect noise signals generated by running of the fan 40b. Finally, the noise signals collected by the one or more microphones when the fan 40b runs at the different rotation speeds are stored.

For example, the noise database may store a plurality of rotation speeds of the fan 40b and a noise signal of the fan 40b under each of the rotation speeds listed in Table 1.

**Table 1**

| Rotation speed | Noise signal |
|---|---|
| Rotation speed 1 | Noise signal 1 |
| Rotation speed 2 | Noise signal 2 |
| ... | ... |
| Rotation speed n | Noise signal n |

A magnitude of noise generated by running of the fan is not only affected by the rotation speed, but also affected by a size, a material, and the like of the fan. In this embodiment of this application, it is assumed that the size, the material, and the like of the fan 40b of the notebook computer 400 are fixed, and impact of only the rotation speed on the noise signal is considered.

It should be noted that, that the notebook computer 400 stores a plurality of rotation speeds and a noise signal under each of the rotation speeds may be specifically: the notebook computer 400 stores the plurality of rotation speeds and a decibel value and frequency value of the noise signal under each of the rotation speeds.

Table 2 lists specific decibel values, of noise signals of a fan under different rotation speeds, obtained through measurement in experiments.

**Table 2**

| Rotation speed (rpm) | Noise signal | |
|---|---|---|
| | Decibel value (dB) | Frequency value (Hz/kHz) |
| 1760 | 19.8 | Frequency 1 |
| 2480 | 28.5 | Frequency 2 |
| 2980 | 33.4 | Frequency 3 |
| 3510 | 38.5 | Frequency 4 |
| 4020 | 42.4 | Frequency 5 |
| 4530 | 46.3 | Frequency 6 |
| 5050 | 51.8 | Frequency 7 |
| 5530 | 55.7 | Frequency 8 |

The rotation speed in this embodiment of this application may be measured in revolutions per second (rps) or revolutions per minute (rpm). The rotation speeds listed in Table 2 are measured in rpm. A frequency value of a noise signal or a sound signal is measured in hertz (Hz) or kilohertz (kHz). For example, a value range of the frequency 1 to the frequency 8 may be 800-1000 Hz. Sound frequencies audible to humans are from 20 Hz to 20 kHz. Therefore, all the noise signals listed in Table 2 are audible to humans. According to this solution, a noise signal generated by running of the fan can be canceled.

Specifically, before the control chip 40a controls the speaker 42 to send the first sound signal, the control chip 40a may obtain a real-time rotation speed of the fan 40b. Then, the control chip 40a may obtain a noise signal of the fan 40b under the real-time rotation speed, and modulate the noise signal under the real-time rotation speed to obtain the first sound signal whose phase is opposite to that of the noise signal under the real-time rotation speed.

For example, it is assumed that the real-time rotation speed of the fan 40b obtained by the control chip 40a is the rotation speed 2 shown in Table 1. In this case, the control chip 40a can obtain the noise signal 2 under the rotation speed 2 from Table 1. Then, the control chip 40a may modulate the noise signal 2 to obtain the first sound signal whose phase is opposite to that of the noise signal 2.

It should be noted that, for a method for modulating an audio signal by an electronic device (such as the notebook computer 400) to obtain a signal whose phase is opposite to that of the audio signal, reference may be made to related descriptions in conventional technologies, and details are not described herein in this embodiment of this application.

In some other embodiments, a sound source of the first sound signal may be provided by a noise database recorded in advance. A difference lies in that, in the embodiment, the noise database stores reverse-phase acoustic waves of noise signals of the fan 40b under a plurality of rotation speeds rather than noise signals of the fan 40b under a plurality of rotation speeds.

The reverse-phase acoustic waves of the noise signals of the fan 40b under the plurality of rotation speeds may be configured in the notebook computer 400 after the noise signals are collected and processed before delivery of the notebook computer 400.

For example, one or more microphones may be placed around the fan 40b of the notebook computer 400. Then, the fan 40b of the notebook computer 400 may be controlled to run at different rotation speeds, and the one or more microphones are controlled to collect noise signals generated by running of the fan 40b. In this way, the noise signals collected by the one or more microphones when the fan 40b runs at the different rotation speeds can be obtained. Then, a noise signal under each of the rotation speeds may be modulated to obtain a corresponding reverse-phase acoustic wave. A reverse-phase acoustic wave of a noise signal and the noise signal have opposite phases and a same frequency. Finally, the plurality of rotation speeds of the fan 40b and the reverse-phase acoustic wave of the noise signal of the fan 40b under each of the rotation speeds may be stored.

For example, the plurality of rotation speeds of the fan 40b and the reverse-phase acoustic wave of the noise signal of the fan 40b under each of the rotation speeds may be stored in the control chip 40a of the notebook computer 400. Alternatively, the plurality of rotation speeds of the fan 40b and the reverse-phase acoustic wave of the noise signal of the fan 40b under each of the rotation speeds may be stored in a memory of the notebook computer 400.

For example, the noise database may store a plurality of rotation speeds of the fan 40b and a reverse-phase acoustic wave of a noise signal of the fan 40b under each of the rotation speeds listed in Table 3.

**Table 3**

| | |
|---|---|
| Rotation speed | Reverse-phase acoustic wave of a noise signal |
| Rotation speed 1 | Reverse-phase acoustic wave 1 |
| Rotation speed 2 | Reverse-phase acoustic wave 2 |
| ... | ... |
| Rotation speed n | Reverse-phase acoustic wave n |

Specifically, before the control chip 40a controls the speaker 42 to send the first sound signal, the control chip 40a may obtain a real-time rotation speed of the fan 40b. Then, the control chip 40a may obtain a reverse-phase acoustic wave of a noise signal of the fan 40b under the real-time rotation speed, to obtain the first sound signal whose phase is opposite to that of the noise signal under the real-time rotation speed. The reverse-phase acoustic wave is the first sound signal.

For example, it is assumed that the real-time rotation speed of the fan 40b obtained by the control chip 40a is the rotation speed n shown in Table 3. In this case, the control chip 40a can obtain the reverse-phase acoustic wave n of a noise signal under the rotation speed n from Table 3, so as to obtain the first sound signal whose phase is opposite to that of the noise signal under the rotation speed n.

In the embodiment, the notebook computer 400 can directly obtain the reverse-phase acoustic wave (namely, the first sound signal) of the noise signal under the real-time rotation speed n through query based on the real-time rotation speed of the fan 40b, with no need to modulate the noise signal to obtain the first sound signal. In this way, a processing procedure of the notebook computer 400 can be simplified, thereby shortening a time from when the fan 40b starts to run to when the notebook computer 400 sends the first sound signal, and canceling fan noise in a timely manner. In addition, a calculation amount of the notebook computer 400 can also be reduced, thereby reducing power consumption of the notebook computer 400.

In some other embodiments, a sound source of the first sound signal may be collected by a microphone in the notebook computer 400 in real time. Specifically, the notebook computer 400 may further include one or more first microphones. The first microphone may be disposed inside the chassis of the notebook computer 400 at a position close to the fan 40b. The first microphone is configured to perform directional sound pickup on the fan 40b.

If the fan 40b is running, before the control chip 40a controls the speaker 42 to send the first sound signal, the control chip 40a may control the first microphone to collect a second noise signal generated by running of the fan 40b. Then, the control chip 40a may modulate the second noise signal collected by the first microphone, to obtain the first sound signal whose phase is opposite to that of the second noise signal and whose frequency is the same as that of the second noise signal.

For example, if the fan 40b is running, the control chip 40a may send a second control command to the first microphone. The second control command may also be referred to as a sound pickup instruction or a recording instruction. The second control command is used to instruct the first microphone to start to collect a sound signal.

That the first microphone is disposed inside the chassis of the notebook computer 400 may be specifically: the first microphone is disposed inside the base 44 of the notebook computer 400. The first microphone may also be referred to as a front-end microphone. For example, as shown in FIG. 5 or FIG. 8, a front-end microphone 52-1, a front-end microphone 52-2, a front-end microphone 52-3, and a front-end microphone 52-4 are disposed inside the base 44.

For example, the first microphone may be disposed on any side of an air exhaust vent of the fan 40b. For example, as shown in FIG. 5 or FIG. 8, the front-end microphone 52-1 and the front-end microphone 52-2 are disposed on the right side of the air exhaust vent of the fan 40b.

Alternatively, the first microphone may be disposed at a position at a preset distance from an air exhaust vent of the fan 40b. For example, as shown in FIG. 5 or FIG. 8, the front-end microphone 52-3 and the front-end microphone 52-4 are disposed at positions at the preset distance from the fan 40b. A value of the preset distance ranges from 1 centimeter (cm) to 10 cm.

It should be noted that the first microphone shall not be disposed on an air duct of the air exhaust vent of the fan 40b. If the first microphone is disposed on the air duct of the air exhaust vent of the fan 40b, additional noise may be generated, which affects a sound pickup effect.

In some other embodiments, the notebook computer 100 may include not only the first microphone (namely, the front-end microphone) but also a second microphone. The second microphone may be referred to as a back-end microphone. The second microphone is disposed outside the chassis of the notebook computer 400 at a position close to the touchpad 47. For example, as shown in FIG. 4 or FIG. 7, the notebook computer 100 further includes a second microphone 46. The second microphone 46 is configured to perform directional sound pickup on a sound signal obtained after the first sound signal cancels a noise signal generated by running of the fan 40b.

Specifically, if the fan is running, the control chip 40a may control the first microphone (namely, the front-end microphone, such as at least one of the front-end microphone 52-1, the front-end microphone 52-2, the front-end microphone 52-3, and the front-end microphone 52-4) to collect the second noise signal generated by the fan 40b, and control the second microphone 46 to collect a second sound signal. The second sound signal includes a sound signal obtained after the first sound signal cancels the first noise signal. Then, the control chip 40a may compare the second noise signal and the second sound signal, and adjust, based on a comparison result, the first sound signal output by the speaker so as to cancel the noise signal generated by running of the fan 40b.

The second microphone 46 is disposed on a housing of the base 44 of the notebook computer 100 at the position close to the touchpad 47. In other words, the second microphone 46 is close to a position of the human ear. Therefore, the second sound signal collected by the second microphone 46 (namely, the back-end microphone) may be considered as a sound signal heard by the human ear. In this embodiment of this application, the notebook computer 400 may compare a real-time noise signal (namely, the second noise signal) generated by running of the fan 40b and the second sound signal, and use the comparison result as a feedback to adjust the first sound signal output by the speaker 42. In this way, a fan noise cancellation effect of the notebook computer 400 can be further improved.

The second sound signal may include not only the sound signal obtained after the first sound signal cancels the first noise signal (referred to as a canceled fan noise signal) but also an ambient sound signal around the notebook computer 400, a sound signal of the user, a sound signal generated by operating the notebook computer 400 by the user (also referred to as an operation sound signal, such as a keystroke sound), and the like.

The notebook computer 400 (such as the control chip 40a in the notebook computer 400) may use the second noise signal to identify the "canceled fan noise signal" in the second sound signal. Then, the notebook computer 400 may determine whether a decibel value of the canceled fan noise signal is greater than a preset noise threshold. If the decibel value of the canceled fan noise signal is greater than the preset noise threshold, the notebook computer 400 may use the comparison result as the feedback to adjust the first sound signal output by the speaker 42. If the decibel value of the canceled fan noise signal is less than or equal to the preset noise threshold, the notebook computer 400 does not need to use the comparison result as the feedback to adjust the first sound signal output by the speaker 42.

It should be noted that, when the sound source of the first sound signal is provided by the noise database recorded in advance, if the internal speaker is selected to play the first sound signal, a position of the microphone for recording the noise database may be set according to the position of the front-end microphone (namely, the first microphone); or if the external speaker is selected to play the first sound signal, a position of the microphone for recording the noise database may be set according to the position of the back-end microphone (namely, the second microphone).

In some other embodiments, the control chip 40a may further detect whether the fan 40b stops running. If the fan 40b stops running, the control chip 40a may control the speaker 42 to stop sending the first sound signal. This can prevent the first sound signal sent by the speaker 42 from generating additional noise.

An embodiment of this application further provides a fan noise reduction method for a notebook computer. The method is applied to the notebook computer (such as the notebook computer 400) in the foregoing embodiments. Components of the notebook computer 400 can work in cooperation to implement the corresponding functions in the foregoing embodiments, so as to perform the fan noise reduction method for a notebook computer.

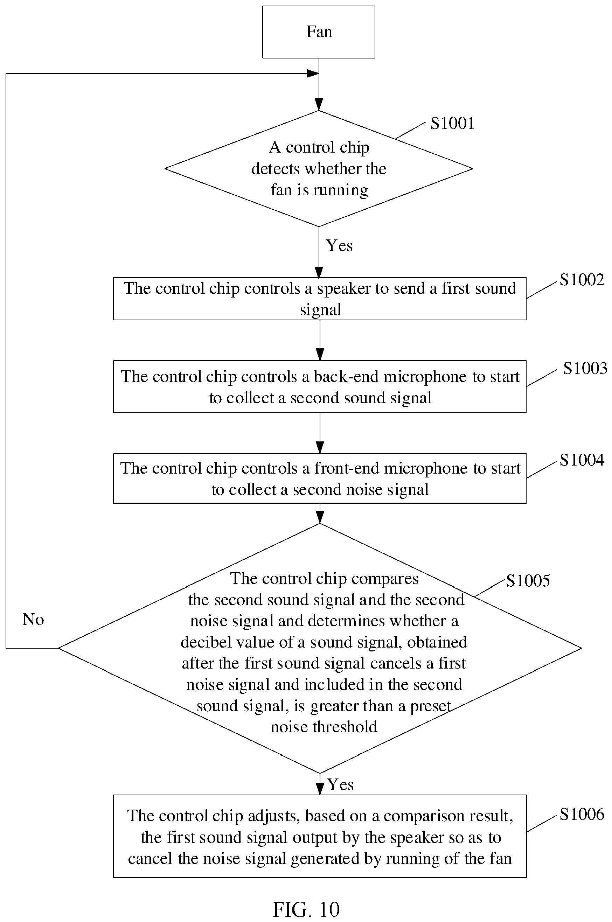

Referring to FIG. 10, the method in this embodiment of this application is described by using an example in which the notebook computer includes a control chip, a fan, a speaker, a front-end microphone, and a back-end microphone.

Specifically, the control chip may perform S1001 shown in FIG. 10, that is, detect whether the fan is running. The detecting, by the control chip, whether the fan is running may also be replaced with detecting, by the control chip, whether the fan is started. If the control chip detects that the fan is running, the control chip may perform S1002 to S1004. S1001 is optional.

S1002: The control chip controls the speaker to send a first sound signal. The first sound signal and a first noise signal that is generated by running of the fan have opposite phases and a same frequency. The first sound signal is used to cancel the first noise signal. For detailed descriptions of a sound source of the first sound signal, refer to descriptions in the foregoing embodiments. Details are not described herein. S1003: The control chip controls the back-end microphone to start to collect a second sound signal. The second sound signal includes a sound signal obtained after the first sound signal cancels the first noise signal. S1004: The control chip controls the front-end microphone to start to collect a second noise signal. The second noise signal is a real-time noise signal generated by running of the fan.

Then, the control chip may perform S1005, that is, compare the second sound signal and the second noise signal and determine whether a decibel value of the sound signal obtained after the first sound signal cancels the first noise signal (referred to as a canceled fan noise signal) included in the second sound signal is greater than a preset noise threshold. If the decibel value of the canceled fan noise signal is greater than the preset noise threshold, the control chip may perform S1006, that is, adjust, based on a comparison result, the first sound signal output by the speaker so as to cancel the noise signal generated by running of the fan. If the decibel value of the canceled fan noise signal is less than or equal to the preset noise threshold, the control chip may continue to perform S1001.

An embodiment of this application further provides a chip system. The chip system may be the foregoing control chip. The chip system may be applied to a notebook computer that includes a fan, a speaker, a microphone, and a memory. The notebook computer can dissipate heat by using the fan. Running of the fan may generate a first noise signal. The notebook computer can play a first sound signal by using the speaker.

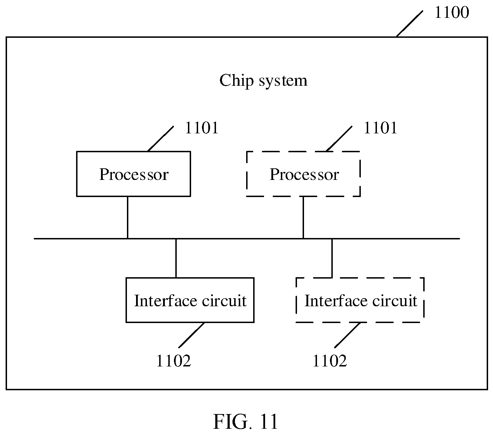

For example, a chip system 1100 shown in FIG. 11 may be applied to a notebook computer that includes a fan, a speaker, a microphone, and a memory. The chip system 1100 includes at least one processor 1101 and at least one interface circuit 1102. The processor 1101 and the interface circuit 1102 may be interconnected by a line. For example, the interface circuit 1102 may be configured to receive a signal from another apparatus (such as a memory of a notebook computer). For another example, the interface circuit 1102 may be configured to send signals to other apparatuses (for example, the processor 1101). For example, the interface circuit 1102 may read instructions stored in the memory and send the instructions to the processor 1101. When the instructions are executed by the processor 1101, the notebook computer may be enabled to perform the steps in the foregoing embodiments. Certainly, the system-on-chip may further include other discrete devices. This is not specifically limited in this embodiment of this application.

An embodiment of this application further provides a computer storage medium, where the computer storage medium includes computer instructions. When the computer instructions are run on the foregoing notebook computer, the notebook computer is enabled to execute the functions or steps that are executed by the notebook computer 400 in the foregoing method embodiments.

An embodiment of this application further provides a computer program product, where when the computer program product runs on a computer, the computer is enabled to execute the functions or steps that are executed by the notebook computer in the foregoing method embodiments.

Based on the description of the foregoing implementations, a person skilled in the art may clearly understand that, for the purpose of convenient and brief description, division of the foregoing functional modules is used as an example for description. In an actual application, the foregoing functions may be allocated to different functional modules and implemented based on a requirement, that is, an internal structure of the apparatus is divided into different functional modules to implement all or a part of the functions described above.

In the several embodiments provided in this application, it should be understood that the disclosed apparatus and method may be implemented in other manners. For example, the described apparatus embodiments are merely examples. For example, the division of modules or units is merely logical function division and may be other division in actual implementation. For example, a plurality of units or components may be combined or integrated into another apparatus, or some features may be ignored or may not be performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate and parts displayed as units may be one physical unit or a plurality of physical units, that is, the parts may be located in one position or distributed in a plurality of different positions. Some or all of the units may be selected based on actual requirements to achieve the objectives of the solutions of the embodiments.

In addition, function units in the embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such an understanding, the technical solutions in the embodiments of this application essentially, or the part contributing to the prior art, or all or a part of the technical solutions may be implemented in a form of a software product. The software product is stored in a storage medium and includes several instructions for instructing a device (which may be a singlechip microcomputer, a chip, or the like) or a processor (processor) to perform all or a part of the steps of the method described in each embodiment of this application. The foregoing storage medium includes any medium that can store program code, such as a USB flash drive, a removable hard disk, a read only memory (read only memory, ROM), a random access memory (random access memory, RAM), a magnetic disk, or an optical disc.

The foregoing content is merely specific implementations of this application, but is not intended to limit the protection scope of this application. Any variation or replacement within the technical scope disclosed in this application shall fall within the protection scope of this application. Therefore, the protection scope of this application shall be subject to the protection scope of the claims.

## Claims

1. A fan noise reduction method for a notebook computer, wherein the notebook computer comprises a control chip, a speaker, and a fan; the control chip and the fan are disposed inside a chassis of the notebook computer; the speaker is an internal speaker disposed inside the chassis or the speaker is an external speaker disposed outside the chassis; and the method comprises:
controlling, by the control chip, the speaker to send a first sound signal, wherein
the first sound signal and a first noise signal that is generated by running of the fan have opposite phases and a same frequency, and the first sound signal is used to cancel the first noise signal.

2. The method according to claim 1, wherein the speaker is the external speaker; and
the speaker is disposed in a base of the notebook computer at a position close to a keyboard or touchpad of the notebook, and an included angle between a sound emitting direction of the speaker and a plane in which the keyboard or the touchpad is located is within a second preset angle range, wherein
the second preset angle range is determined based on statistics of a large number of users using the notebook computer about included angles between a second direction and the plane in which the keyboard or the touchpad is located; and the second direction is parallel to a connection line between the position of the speaker and an ear of the user when the user is using the notebook computer.

3. The method according to claim 1, wherein the speaker is the external speaker; and
the speaker is disposed in a bezel of a display of the notebook computer, and an included angle between a sound emitting direction of the speaker and a plane in which the display is located is within a first preset angle range, wherein
the first preset angle range is determined based on statistics of a large number of users using the notebook computer about included angles between a first direction and the plane in which the display is located, wherein the first direction is parallel to a connection line between a position of the speaker and an ear of the user when the user is using the notebook computer.

4. The method according to claim 1, wherein the speaker is the internal speaker, and the speaker is located inside the chassis at a position close to the fan, wherein
an included angle between a sound emitting direction of the speaker and an air exhaust direction of the fan is (0, q], wherein q is greater than or equal to 0° and q is less than a first preset angle threshold.

5. The method according to any one of claims 1 to 4, wherein before the controlling, by the control chip, the speaker to send a first sound signal, the method further comprises:
obtaining, by the control chip, a real-time rotation speed of the fan; and
controlling the speaker to play a reverse-phase acoustic wave corresponding to the real-time rotation speed, wherein the reverse-phase acoustic wave corresponding to the real-time rotation speed and a noise signal of the fan under the real-time rotation speed have opposite phases and a same frequency, and the reverse-phase acoustic wave corresponding to the real-time rotation speed is the first sound signal, wherein
the notebook computer prestores a plurality of rotation speeds of the fan and a reverse-phase acoustic wave corresponding to each of the rotation speeds, wherein the plurality of rotation speeds comprise the real-time rotation speed.

6. The method according to any one of claims 1 to 4, wherein the notebook computer further comprises a first microphone and a second microphone, wherein the first microphone is disposed on any side of an air exhaust vent of the fan and configured to perform directional sound pickup on the fan, and the second microphone is disposed on the outer side of the chassis of the notebook computer at a position close to the touchpad and configured to perform directional sound pickup on a sound signal obtained after the first sound signal cancels a noise signal generated by running of the fan; and the method further comprises:
controlling, by the control chip, the first microphone to collect a second noise signal generated by the fan and the second microphone to collect a second sound signal, wherein the second sound signal comprises a sound signal obtained after the first sound signal cancels the first noise signal; and
comparing, by the control chip, the second noise signal and the second sound signal, and adjusting, based on a comparison result, the first sound signal output by the speaker so as to cancel the noise signal generated by running of the fan.

7. The method according to any one of claims 1 to 3, wherein the notebook computer further comprises a first microphone, wherein the first microphone is disposed on any side of an air exhaust vent of the fan and configured to perform directional sound pickup on the fan; and the method further comprises:
controlling, by the control chip, the first microphone to collect a second noise signal generated by running of the fan; and
modulating, by the control chip, the second noise signal to obtain the first sound signal whose phase is opposite to that of the second noise signal and whose frequency is the same as that of the second noise signal.

8. The method according to claim 7, wherein the notebook computer further comprises a second microphone, wherein the second microphone is disposed on the outer side of the chassis of the notebook computer at a position close to the touchpad and configured to perform directional sound pickup on a sound signal obtained after the first sound signal cancels a noise signal generated by running of the fan; and the method further comprises:
controlling, by the control chip, the second microphone to collect a second sound signal, wherein the second sound signal comprises a sound signal obtained after the first sound signal cancels the first noise signal; and
comparing, by the control chip, the second noise signal and the second sound signal, and adjusting, based on a comparison result, the first sound signal output by the speaker so as to cancel the noise signal generated by running of the fan.

9. The method according to any one of claims 1 to 8, wherein that the first sound signal and the first noise signal have opposite phases comprises:
a phase difference between the first sound signal and the first noise signal is [180°-p, 180°+p], wherein p is greater than or equal to 0° and p is less than a second preset angle threshold.

10. Anotebook computer, wherein the notebook computer comprises a control chip, a speaker, and a fan, wherein the control chip and the fan are disposed inside a chassis of the notebook computer, and the speaker is an internal speaker disposed inside the chassis or the speaker is an external speaker disposed outside the chassis;
the control chip is configured to transmit a first sound signal to the speaker, wherein the first sound signal and a first noise signal that is generated by running of the fan have opposite phases and a same frequency, and the first sound signal is used to cancel the first noise signal; and
the speaker is configured to send the first sound signal.

11. The notebook computer according to claim 10, wherein the speaker is the external speaker; and
the speaker is disposed in a base of the notebook computer at a position close to a keyboard or touchpad of the notebook, and an included angle between a sound emitting direction of the speaker and a plane in which the keyboard or the touchpad is located is within a second preset angle range, wherein
the second preset angle range is determined based on statistics of a large number of users using the notebook computer about included angles between a second direction and the plane in which the keyboard or the touchpad is located; and the second direction is parallel to a connection line between the position of the speaker and an ear of the user when the user is using the notebook computer.

12. The notebook computer according to claim 10, wherein the speaker is the external speaker; and
the speaker is disposed in a bezel of a display of the notebook computer, and an included angle between a sound emitting direction of the speaker and a plane in which the display is located is within a first preset angle range, wherein
the first preset angle range is determined based on statistics of a large number of users using the notebook computer about included angles between a first direction and the plane in which the display is located, wherein the first direction is parallel to a connection line between a position of the speaker and an ear of the user when the user is using the notebook computer.

13. The notebook computer according to claim 10, wherein the speaker is the internal speaker, and the speaker is located inside the chassis at a position close to the fan, wherein
an included angle between a sound emitting direction of the speaker and an air exhaust direction of the fan is (0, q], wherein q is greater than or equal to 0° and q is less than a first preset angle threshold.

14. The notebook computer according to any one of claims 10 to 13, wherein the control chip is further configured to obtain a real-time rotation speed of the fan; and
the control chip is further configured to obtain a reverse-phase acoustic wave corresponding to the real-time rotation speed, wherein the reverse-phase acoustic wave corresponding to the real-time rotation speed and a noise signal of the fan under the real-time rotation speed have opposite phases and a same frequency, and the reverse-phase acoustic wave corresponding to the real-time rotation speed is the first sound signal, wherein
the notebook computer prestores a plurality of rotation speeds of the fan and a reverse-phase acoustic wave corresponding to each of the rotation speeds, wherein the plurality of rotation speeds comprise the real-time rotation speed.

15. The notebook computer according to any one of claims 10 to 13, wherein the notebook computer further comprises a first microphone and a second microphone, wherein the first microphone is disposed on any side of an air exhaust vent of the fan and configured to perform directional sound pickup on the fan, and the second microphone is disposed on the outer side of the chassis of the notebook computer at a position close to the touchpad and configured to perform directional sound pickup on a sound signal obtained after the first sound signal cancels a noise signal generated by running of the fan;
the control chip is further configured to instruct the first microphone and the second microphone to collect sound signals;
the first microphone is configured to collect, in response to an instruction of the control chip, a second noise signal generated by the fan;
the second microphone is configured to collect a second sound signal in response to an instruction of the control chip, wherein the second sound signal comprises a sound signal obtained after the first sound signal cancels the first noise signal; and
the control chip is further configured to compare the second noise signal and the second sound signal, and adjust, based on a comparison result, the first sound signal output by the speaker so as to cancel the noise signal generated by running of the fan.

16. The notebook computer according to any one of claims 10 to 12, wherein the notebook computer further comprises a first microphone, wherein the first microphone is disposed on any side of an air exhaust vent of the fan and configured to perform directional sound pickup on the fan;
the control chip is further configured to instruct the first microphone to collect a sound signal;
the first microphone is configured to collect, in response to an instruction of the control chip, a second noise signal generated by the fan; and
the control chip is further configured to modulate the second noise signal to obtain the first sound signal whose phase is opposite to that of the second noise signal and whose frequency is the same as that of the second noise signal.

17. The notebook computer according to claim 16, wherein the notebook computer further comprises a second microphone, wherein the second microphone is disposed on the outer side of the chassis of the notebook computer at a position close to the touchpad and configured to perform directional sound pickup on a sound signal obtained after the first sound signal cancels a noise signal generated by running of the fan;
the control chip is further configured to instruct the second microphone to collect a sound signal;
the second microphone is configured to collect a second sound signal in response to an instruction of the control chip, wherein the second sound signal comprises a sound signal obtained after the first sound signal cancels the first noise signal; and
the control chip is further configured to compare the second noise signal and the second sound signal, and adjust, based on a comparison result, the first sound signal output by the speaker so as to cancel the noise signal generated by running of the fan.

18. The notebook computer according to any one of claims 10 to 17, wherein the control chip is further configured to:
detect, by the control chip, whether the fan stops running; and
if the fan stops running, control, by the control chip, the speaker to stop sending the first sound signal.

19. The notebook computer according to any one of claims 10 to 18, wherein that the first sound signal and the first noise signal have opposite phases comprises:
a phase difference between the first sound signal and the first noise signal is [180°-p, 180°+p], wherein p is greater than or equal to 0° and p is less than a second preset angle threshold.

20. A computer-readable storage medium, comprising computer instructions, wherein when the computer instructions are run on a notebook computer, the notebook computer is enabled to perform the method according to any one of claims 1 to 9.
